(19) Europäisches Patentamt
European Patent Office
Office européen des brevets

(11) **EP 3 134 908 B1**

(12) **EUROPEAN PATENT SPECIFICATION**

(45) Date of publication and mention
of the grant of the patent:
**28.08.2019  Bulletin 2019/35**

(51) Int Cl.:
**H01G 9/20** (2006.01)   **H01L 51/05** (2006.01)

(21) Application number: **15717507.6**

(22) Date of filing: **22.04.2015**

(86) International application number:
**PCT/EP2015/058729**

(87) International publication number:
**WO 2015/162184 (29.10.2015 Gazette 2015/43)**

(54) **ELECTRONIC DEVICE COMPRISING NANOGAP ELECTRODES AND NANOPARTICLES**

ELEKTRONISCHE VORRICHTUNG MIT NANOSPALTELEKTRODEN UND NANOPARTIKELN

DISPOSITIF ÉLECTRONIQUE COMPRENANT DES ÉLECTRODES À NANO-ESPACEMENT ET DES NANOPARTICULES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **22.04.2014  EP 14165507
22.04.2014  US 201414258245**

(43) Date of publication of application:
**01.03.2017  Bulletin 2017/09**

(73) Proprietors:
• **Nexdot
93230 Romainville (FR)**
• **Fonds de l'ESPCI - Georges Charpak
75005 Paris (FR)**

(72) Inventors:
• **LHUILLIER, Emmanuel
93230 Romainville (FR)**
• **DUBERTRET, Benoît
93230 Romainville (FR)**

(74) Representative: **Icosa
83 avenue Denfert-Rochereau
75014 Paris (FR)**

(56) References cited:
WO-A1-2012/050533   WO-A1-2013/170103
WO-A2-2009/143328   US-A1- 2008 108 172

• PARK HONGKUN ET AL: "Fabrication of metallic electrodes with nanometer separation by electromigration", APPLIED PHYSICS LETTERS, AMERICAN INSTITUTE OF PHYSICS, US, vol. 75, no. 2, 12 July 1999 (1999-07-12), pages 301-303, XP012024016, ISSN: 0003-6951, DOI: 10.1063/1.124354
• DAVID L. KLEIN, ET AL.: "An approach to electrical studies of single nanocrystals", APPLIED PHYSICS LETTERS, AMERICAN INSTITUTE OF PHYSICS, US, vol. 68, no. 18, 29 April 1996 (1996-04-29), pages 2574-2576, XP012015166, ISSN: 0003-6951, DOI: 10.1063/1.116188
• AMIR ZABET-KHOSOUSI ET AL: "Charge Transport in Nanoparticle Assemblies", CHEMICAL REVIEWS, vol. 108, no. 10, 8 October 2008 (2008-10-08), pages 4072-4124, XP055083337, ISSN: 0009-2665, DOI: 10.1021/cr0680134
• LIU B ET AL: "Controllable nanogap fabrication on microchip by chronopotentiometry", ELECTROCHIMICA ACTA, ELSEVIER SCIENCE PUBLISHERS, BARKING, GB, vol. 50, no. 15, 20 May 2005 (2005-05-20), pages 3041-3047, XP027694359, ISSN: 0013-4686 [retrieved on 2005-05-20]
• SILVIA PEDETTI ET AL: "Optimized Synthesis of CdTe Nanoplatelets and Photoresponse of CdTe Nanoplatelets Films", CHEMISTRY OF MATERIALS, vol. 25, no. 12, 21 May 2013 (2013-05-21), pages 2455-2462, XP055124223, ISSN: 0897-4756, DOI: 10.1021/cm4006844

- MOON SUNG KANG ET AL: "High Carrier Densities Achieved at Low Voltages in Ambipolar PbSe Nanocrystal Thin-Film Transistors", NANO LETTERS, vol. 9, no. 11, 11 November 2009 (2009-11-11), pages 3848-3852, XP055124229, ISSN: 1530-6984, DOI: 10.1021/nl902062x
- DAEHA JOUNG ET AL: "High yield fabrication of chemically reduced graphene oxide field effect transistors by dielectrophoresis", NANOTECHNOLOGY, IOP, BRISTOL, GB, vol. 21, no. 16, 23 April 2010 (2010-04-23), page 165202, XP020174805, ISSN: 0957-4484
- W. I. Park ET AL: "ZnO Nanorod Logic Circuits", ADVANCED MATERIALS, vol. 17, no. 11, 6 June 2005 (2005-06-06), pages 1393-1397, XP055532213, DE ISSN: 0935-9648, DOI: 10.1002/adma.200401732
- Talin Ayvazian ET AL: "Electroluminescent, Polycrystalline Cadmium Selenide Nanowire Arrays", ACS Nano, vol. 7, no. 10, 22 October 2013 (2013-10-22), pages 9469-9479, XP055532217, US ISSN: 1936-0851, DOI: 10.1021/nn4043546
- Talin Ayvazian ET AL: "Electroluminescent, Polycrystalline Cadmium Selenide Nanowire Arrays", ACS Nano, vol. 7, no. 10, 22 October 2013 (2013-10-22), pages 9469-9479, XP055532219, US ISSN: 1936-0851, DOI: 10.1021/nn4043546

**Description**

**FIELD OF INVENTION**

The present invention relates to the field of nanotechnology and especially to a device comprising nanogap electrodes and nanoparticles. The present invention also pertains to processes for preparing said device and to applications in photodetection using said device.

**BACKGROUND OF INVENTION**

The use of colloidal quantum dots (CQD) in optoelectronic devices requests both the fine control of their optical and transport properties. Transport in a CQD film is a multiscale process where hopping process occur at the nanoparticle scale and film morphology (cracks...) is playing a role at the micrometric scale. Consequently not only the inter-particle tunnel barrier needs to be tuned to adjust the coupling but a good long scale ordering is also requested. Atomic-ligand passivation (such as $S^{2-}$, $SCN^-$ or $Cl^-$ and metal chalcogenides ligands) do address the shortening and lowering of the inter-particle tunnel barrier but they generally request polar solvent which come at the price of a more limited range of method to build the nanoparticle film. With such passivation the film remains strongly disordered. In disordered film the photo-activated carrier still need to perform a random walk to reach the electrodes which typically includes hundred to thousand steps. To avoid this inefficient transport process several strategies have been developed among which the realization of QD-graphene hybrid to uncouple the absorption from the transport process or the use of nanogap.

Park et al. discloses a single-electron transistor based on CdSe quantum dots placed between two electrodes by solution-phase deposition (Park et al., Applied Physics Letters, 75, pp. 301, 1999). Klein et al. discloses electrical measurements of single Au and CdSe spherical nanocrystals between two electrodes spaced by a few nanometers (Klein et al., Applied Physics Letters, 68, pp. 2574, 1996). US 2008/0108172 discloses a nanodevice comprising a carbon nanotube bridging two electrodes.

With a nanometer long channel, capable of accommodating nanoparticles, the nanoparticle can be directly connected to the electrodes which avoids the post absorption diffusion transport of the carrier and its trapping. Moreover the short transport length reduces the transit time which tends to increase the photoconductive gain of the device. To realize these nanogaps several methods have been proposed including e-beam lithography, self-alignment method, electromigration or shadowing methods. In spite of this interest quantum dots remain tricky to connect to the electrodes and a poor overlap is obtained while using a spherical particle which size is of the same order of magnitude of the gap size.

One of the object of the present invention is thus to use nanoplatelets for connecting nanogap electrodes.

Motivation for nanogap based photodetector is first the increase of the gain. In a photodetector the responsivity, i.e. the ability of the active material to convert the light photon flux into a current expressed in $A.W^{-1}$; is proportional to the product of the internal quantum efficiency by the gain $R < \eta g$. The gain is itself the ratio of the photocarrier lifetime $\tau$ divided by the transit time $\tau_{transit}$, where the transit time is the time for a photogenerated charge to reach the electrode:

$$g = \frac{\tau}{\tau_{transit}}.$$

The internal quantum efficiency is the ratio of the number of charge carriers collected by the electronic device to the number of photons absorbed by the active material. The smallest the spacing between the electrodes the shortest the time for the carrier to reach the electrodes. As a consequence reducing the electrodes spacing from a few micrometers to a few nanometers potentially increases the gain by a factor 1 000.

Other motivation for nanogap based photodetector is the fact that the volume reduction of the nanoparticle makes that it is easier to get rid of the defect of the film morphology. Indeed for micrometer scale film is common to observe crack formation into the film.

These cracks in particular tend to be formed when a ligand exchange procedure on film is processed.

Another attractive aspect for nanogap based photodetector is the fact that transport is no longer driven by hopping. Consequently the noise level is not as high as the one associated with hopping transport.

Finally another interest of this geometry of device is to build electroluminescent system based on colloidal QD. So far most of the effort to build Led using colloidal nanoparticle as active material rely on the encapsulation of a thin layer of nanoparticle between one hole and one electron injection layer. However the p type layer is generally a conductive polymer. This solution presents two main drawbacks which are (i) a limited lifetime of the device and (ii) a device which can not be used in the infrared (IR) due to the high absorption of the organic layer. In order to build IR operating electroluminescent device it is thus very appealing to avoid any organic material. The nanogap or nanotrench of the invention which can be operated in the high electric field regime allows to apply energy drop per particle of the order of the band edge energy which is the requested condition to achieve electroluminescence. Coupling a nanotrench with a narrow band gap material such as lead or mercury chalcogenides is consequently a possible path to build organic free IR emitting device.

Consequently the use of nanoplatelets for connecting nanogap electrodes could lead to outstanding properties, such as responsivity and/or specific detectivity, which have not been reported until now in the prior art.

## SUMMARY

This invention thus relates to an electronic device according to claim 1.

According to one embodiment, the nanogap has a size d ranging from 0.1 nanometer to 1 000 nanometers, preferably from 0.25 nanometer to 500 nanometers, more preferably from 1 nanometer to 100 nanometers, even more preferably from 10 nanometers to 80 nanometers.

According to one embodiment, the nanogap has a length L ranging from 1 nanometer to 10 millimeters, preferably from 5 nanometers to 1 millimeter, more preferably from 10 nanometers to 100 micrometers, even more preferably from 50 nanometers to 10 micrometers.

According to the invention, the at least one nanoparticle is a nanosheet, a nanoplatelet, a nanoplate, a nanowall, a nanodisk, a nanoribbon, or a nanobelt. According to a preferred embodiment, the at least one nanoparticle is a semiconductor nanoplatelet.

According to one embodiment, the electronic device further comprises an electrolyte on the at least one nanoparticle.

The present invention also relates to a method of manufacturing the electronic device of the present invention, according to claim 7.

According to one embodiment, the method of formation on a substrate of at least two electrodes spaced by a nanogap is selected from electromigration, electrodeposition, mechanically controlled break junctions, e-beam lithography, self-alignment methods, lift-off methods, shadowing methods, on-wire lithography, nanotube masks.

According to one embodiment, the method of deposition of at least one nanoparticle onto the nanogap is selected from drop casting, spin coating, dip coating, spray casting, screen printing, inkjet printing, sputtering techniques, evaporation techniques, electrophoretic deposition, gravure printing, flexographic printing or vacuum methods.

The present invention also relates to an electronic device wherein a pn junction is formed between the at least two electrodes.

According to one embodiment, the electronic device of the present invention is used as photodetector, transistor or phototransistor. According to one embodiment, the electronic device of the present invention is used as optical modulator. According to one embodiment, the electronic device of the present invention is used as an electrical diode, a photovoltaic solar cell or an electroluminescent component.

The present invention also relates to a light-emitting device and laser comprising an electronic device according to the invention.

## DEFINITIONS

In the present invention, the following terms have the following meanings:

- As used herein the singular forms "**a**", "**an**", and "**the**" include plural reference unless the context clearly dictates otherwise.

- The term "**about**" is used herein to mean approximately, roughly, around, or in the region of. When the term "about" is used in conjunction with a numerical range, it modifies that range by extending the boundaries above and below the numerical values set forth. In general, the term "about" is used herein to modify a numerical value above and below the stated value by a variance of 20 percent.

- "**Active material**" refers to the material (usually a semiconductor) which carrier density and or electronic state will be tuned by the application of a bias over the electrodes.

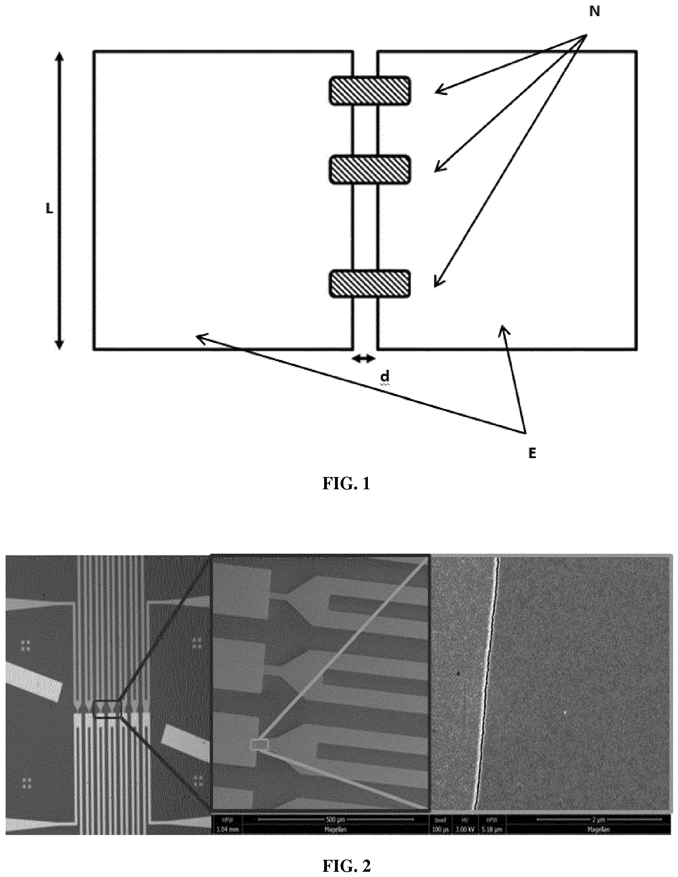

- "**Aspect ratio**" refers generally to the ratio of the lengths in the different dimensions. The aspect ratio of the nanogap refers herein to the ratio of the length of the nanogap **L** (i.e. to the width of the ends of the at least two electrodes spaced by the nanogap or equivalently the length of the side of the at least two electrodes in contact with the gap) to the distance or width between the at least two electrodes spaced by the nanogap **d** (also referred herein as the nanogap size). Thus within the present invention the aspect ratio refers to **L/d,** see figure 1.

- "**Nanogap**" refers herein to spacing, at the nanometer scale, between at least two electrodes. Alternatively the term nanotrench might be also used to describe the same.

- "**Nanogap electrodes**" refers to at least two electrodes spaced by at least one nanogap. "Nanogap electrodes" and "at least two electrodes spaced by a nanogap" are used interchangeably throughout the specification.

- "**Nanogap size**" refers herein to the width of the gap or equivalently to the median inter-electrodes distance **d**, see figure 1.

- "**Nanogap length**" refers to the length of each electrode L, see figure 1.

- "**Nanoparticle**" refers to a particle of any shape having at least one dimension in the 0.1 to 100 nanometers range.

- "**Projected area**" of a nanoparticle refers to the area defined by the projection of the surface of the nanoparticle on the plane defined by the surface of the at least two electrodes spaced by a nanogap in contact with the nanoparticle.

## DETAILED DESCRIPTION

This invention relates to an electronic device according to claim 1.

The device of the present invention comprises a substrate on which the at least two electrodes spaced by a nanogap are formed, manufactured and/or deposited.

According to a first embodiment, the substrate is formed from silicon, silicon dioxide, aluminum oxide, sapphire, germanium, gallium arsenide, an alloy of silicon and germanium, indium phosphide, indium tin oxide, fluorine doped tin oxide, graphene, glass and its derivative, plastic materials or any material that a person skilled in the art would find suitable.

According to a second embodiment, the substrate is formed from ZnS, ZnSe InP, CdZnTe, ZnTe, GaAs, GaSb, or mixture thereof.

According to an embodiment, the substrate is formed from undoped semiconductor. According to another embodiment, the substrate is formed from slightly doped semiconductor.

According to an embodiment, the substrate is formed from non-conducting polymer.

According to an embodiment, the substrate is formed from an insulating material. According to a preferred embodiment, the substrate is formed from an oxide material acting as an electronic insulator. According to another embodiment, the substrate comprises at least two layers with an oxide layer on the top, acting as an electronic insulator, such as for example $SiO_2$ layer on a Si layer.

According to an embodiment, the substrate is rigid. According to another embodiment, the substrate is flexible and/or stretchable.

According to an embodiment, the substrate is transparent.

According to an embodiment, the substrate is transparent in a wavelength window compatible with the absorption spectrum of the at least one nanoparticle. Compatible means herein that the substrate is at least partly transparent in the range of wavelength wherein the at least one nanoparticle is absorbing. Partly transparent means herein that the substrate has a transmittance of at least 50%, preferably at least 75%, more preferably at least 90%.

According to an embodiment, the substrate is transparent in the visible, i.e. in a wavelength range from about 380 nanometers to about 750 nanometers.

According to an embodiment, the substrate is transparent in the ultraviolet range of wavelength, i.e. in a wavelength range from about 10 nanometers to about 380 nanometers.

According to an embodiment, the substrate is transparent in the infrared range of wavelength, i.e. in the wavelength range from about 750 nanometers to about 1 000 000 nanometers, preferably from about 750 nanometers to about 50 000 nanometers, more preferably from about 750 nanometers to about 3 000 nanometers.

According to one embodiment, the substrate is partly transparent in the visible and/or in the ultraviolet range of wavelength and/or in the infrared range of wavelength.

According to an embodiment, the substrate transparency window is at least 1 nanometer large, preferably at least 10 nanometers large and more preferably above 50 nanometers large.

According to an embodiment, the substrate is transparent in two wavelength windows compatible with the absorption spectrum of the at least one nanoparticle.

According to an embodiment, the substrate transparency window is made of several windows in order to fit the absorption spectrum of the multicolor detector, preferably of several narrow transparency windows i.e. of at most 50 nm large.

According to an embodiment, the substrate is used as back gating. In said embodiment, the substrate is preferentially formed from a conducting contact coated with a dielectric layer, said dielectric contact being formed from silicon dioxide, hafnium dioxide, non-conducting polymer such as PMMA or any other dielectric layer that one skilled in the art would find suitable.

The electronic device of the present invention comprises nanogap electrodes (i.e. at least two electrodes spaced by a nanogap).

According to a first embodiment, the device comprises 2, 3, 4, 5, 6, 7, 8, 9, 10, 11, 12, 13, 14 or 15 electrodes spaced by at least one nanogap.

According to an embodiment, the nanogap is positioned between 2, 3, 4, 5, 6, 7, 8, 9, 10, 11, 12, 13, 14 or 15 electrodes.

According to an embodiment, wherein the device comprises three electrodes, one of them is used as a gate electrode for tuning the carrier density between the two other nanogap electrodes (i.e. in the active material bridging the two other electrodes: the source and the drain electrodes).

According to an embodiment, the device comprises several electrodes (for example 2, 3, 4, 5, 6, 7, 8, 9, 10, 11, 12, 13, 14 or 15 electrodes) forming several nanogaps (for example 1, 2, 3, 4, 5, 6, 7, 8, 9, 10, 11, 12, 13 or 14 nanogaps) in parallel.

According to an embodiment, the device comprises several electrodes (for example 2, 3, 4, 5, 6, 7, 8, 9, 10, 11, 12, 13, 14 or 15 electrodes) forming an array of nanogap.

According to an embodiment, as illustrated in figure 2, the nanogap has a straight shape. According to another embodiment, the nanogap has a serpentin shape. According to an embodiment, the geometry of the nanogap comprises curved edges. According to one embodiment, the at least two electrodes spaced by a nanogap are interdigitated.

According to an embodiment, the nanogap has an aspect ratio **L/d** ranging from 1 to $10^9$, from 100 to $10^9$, from 200 to $10^9$, from 500 to $10^9$, from 1 000 to $10^9$, from 10 000 to $10^9$, from 10 to $10^8$, from 100 to $10^7$, from 1 000 to $10^7$, from 10 to $10^6$, or from 100 to $10^5$.

According to an embodiment, the nanogap has an aspect ratio **L/d** ranging from 1, 10, 100, 200, 500, 1 000, $10^4$ for the lower value to up to $10^5$, $10^6$, $10^7$, $10^8$, $10^9$ for the higher value.

According to an embodiment, the optical area of the device ranges from $10^{-16}$ $m^2$ to 0.1 $m^2$, more preferably $10^{-14}$ $m^2$ to $10^{-7}$ $m^2$, more preferably from $10^{-13}$ $m^2$ to $10^{-8}$ $m^2$ and even more preferably from $10^{-11}$ $m^2$ to $9 \times 10^{-9}$ $m^2$.

According to an embodiment, the size d of the nanogap ranges from 0.1 nanometer to 1 000 nanometers, from 0.1 to 500 nanometers, from 0.1 nanometer to 200 nanometers, from 0.1 nanometers to 100 nanometers, from 1 nanometers to 100 nanometers or from 10 to 100 nanometer.

According to an embodiment, the size d of the nanogap is larger than 1 nm, larger than 2 nm, larger than 5 nm, larger than 10 nm, larger than 25 nm, larger than 50 nm.

According to an embodiment, the size d of the nanogap is less than 1 000 nanometers, less than 200 nanometers, preferably less than 100 nanometers, more preferably less than 75 nanometers, even more preferably less than 50 nanometers.

According to one embodiment, the depth of the nanogap ranges from 0.1 nm to 10 $\mu$m, preferably from 0.1 nm to 1 $\mu$m, more preferably from 1 nm to 100 nm.

According to an embodiment, the length L of the nanogap ranges from 1 nanometer to 10 millimeters, from 5 nanometers to 1 millimeter, from 10 nanometers to 100 micrometers or from 100 nanometers to 100 micrometers. According to an embodiment, at least one of the nanogap electrodes is not tapered or pointed. According to an embodiment, the nanogap electrodes are not tapered or pointed.

According to an embodiment, the nanogap electrodes are formed from metal such as gold, silver, palladium, platinum, copper, titanium, tungsten, aluminum, silver or iron.

According to an embodiment, the nanogap electrodes are formed form transparent conducting layer made for example from transparent conducting oxides such as indium tin oxide, fluorine doped tin oxide, zinc oxide, doped zinc oxide.

According to an embodiment, the nanogap electrodes are formed from non-doped semiconductor or doped semiconductor such as ZnS, ZnSe InP, CdZnTe, ZnTe, GaSb, Si, Sn, Ge, GaAs, AlGaAs, InAs, InP, InGaAs, or mixture thereof.

According to an embodiment, the nanogap electrodes are formed from carbon based materials. According to an embodiment, the nanogap electrodes are not formed from carbon based materials.

According to an embodiment, the nanogap electrodes are formed from the same material. According to another embodiment, the nanogap electrodes are formed from two different materials.

According to an embodiment, the material forming the at least two electrodes spaced by a nanogap is homogeneous. According to another embodiment, the material forming the at least two electrodes spaced by a nanogap is structured of different layers.

In an embodiment, the nanogap electrodes do not comprise an insulator coating.

In an embodiment, the electrodes are coupled to a plasmonic resonator.

In an embodiment, the absorption or emission of the system is boosted by coupling the active material with a plasmonic structure.

In an embodiment, a metallic mirror is deposited below the transport electrodes and reflects the non-absorbed light toward the active material. This material can be made of Au, Al, Ag.

In an embodiment, the plasmonic structure used to boost the optical performance of the device use the contact electrodes to build a resonator.

In an embodiment, the spacing of the electrodes is tuned in order to obtain a plasmonic resonance close to the band edge energy of the optically active material.

The electronic device of the present invention comprises at least two electrodes spaced by a nanogap and bridged by at least one nanoparticle. According to an embodiment, in the device of the present invention each of the at least one nanoparticle bridges at least two electrodes spaced by a nanogap.

According to an embodiment, in the device of the present invention the at least one nanoparticle is used as the active material.

According to the invention, the at least one nanoparticle bridging the at least two electrodes spaced by a nanogap has at least 2% of its projected area overlapping with the at least two electrodes spaced by a nanogap (i.e. the at least one nanoparticle has an overlap area with the at least two electrodes spaced by a nanogap higher than 2% of the area of the at least one nanoparticle). According to an embodiment the at least one nanoparticle bridging the at least two electrodes spaced by a nanogap has at least 5% of its projected surface overlapping with the at least two electrodes spaced by a nanogap. According to an embodiment, the at least one nanoparticle bridging the at least two electrodes spaced by a nanogap has at least 10% of its projected surface overlapping with the at least two electrodes spaced by a nanogap. According to an embodiment, the at least one nanoparticle bridging the at least two electrodes spaced by a nanogap has at least 20% of its projected surface overlapping with the at least two electrodes spaced by a nanogap.

According to an embodiment, the at least one nanoparticle bridging the at least two electrodes spaced by a nanogap has at least 2% of its projected area overlapping with each of the at least two electrodes spaced by a nanogap (i.e. the at least one nanoparticle has an overlap area with each of the at least two electrodes spaced by a nanogap higher than 2% of the area of the at least one nanoparticle). According to an embodiment the at least one nanoparticle bridging the at least two electrodes spaced by a nanogap has at least 2.5% of its projected surface overlapping with each of the at least two electrodes spaced by a nanogap. According to an embodiment, the at least one nanoparticle bridging the at least two electrodes spaced by a nanogap has at least 5% of its projected surface overlapping with each of the at least two electrodes spaced by a nanogap. According to an embodiment, the at least one nanoparticle bridging the at least two electrodes spaced by a nanogap has at least 10% of its projected surface overlapping with each of the at least two electrodes spaced by a nanogap.

According to the invention, the at least one nanoparticle bridging the at least two electrodes spaced by a nanogap is for example nanosheet, nanoplatelet, nanoplate, nanowall, nanodisk, nanoribbon, nanobelt. According to an embodiment, it may be combinations thereof.

According to the invention, the at least one nanoparticle bridging the at least two electrodes spaced by a nanogap is a nanosheet, nanoplatelet, nanoplate, nanowall, nanodisk, nanoribbon, nanobelt, and the like.

According to an embodiment, the at least one nanoparticle is a 2D nanoparticle.

In the present application, the term nanoplatelet has the same meaning as nanosheet, 2D-nanoparticle or quasi 2D-nanoparticle.

According to a preferred embodiment, the at least one nanoparticle bridging the at least two electrodes spaced by a nanogap is a nanoplatelet or nanosheet. According to an embodiment, the at least one nanosheet has a thickness of about 0.3 nm to about 10 mm, about 0.3 nm to about 1 mm, about 0.3 nm to about 100 $\mu$m, about 0.3 nm to about 10 $\mu$m, about 0.3 nm to about 1 $\mu$m, about 0.3 nm to about 500 nm, about 0.3 nm to about 250 nm, about 0.3 nm to about 100 nm, about 0.3 nm to about 50 nm, about 0.3 nm to about 25 nm, about 0.3 nm to about 20 nm, about 0.3 nm to about 15 nm, about 0.3 nm to about 10 nm, about 0.3 nm to about 5 nm.

According to an embodiment, the at least one nanosheet has a lateral dimensions (length and/or width) of at least 1.5 times its thickness. According to an embodiment, the lateral dimensions of the at least one nanosheet are at least 2, 2.5, 3, 3.5, 4, 4.5, 5 times larger than its thickness. According to an embodiment, the lateral dimensions of the nanosheet are from at least 0.45 nm to at least 50 mm.

According to an embodiment, the lateral dimensions of the nanosheet are ranging from at least 2 nm to less than 1 m, from 2 nm to 100 mm, from 2 nm to 10 mm, from 2 nm to 1 mm, from 2 nm to 100 $\mu$m, from 2 nm to 10 $\mu$m, from 2 nm to 1 $\mu$m, from 2 nm to 100 nm, from 2 nm to 10 nm.

According to an embodiment, the at least one nanoparticle bridging the at least two electrodes spaced by a nanogap have an homogeneous composition.

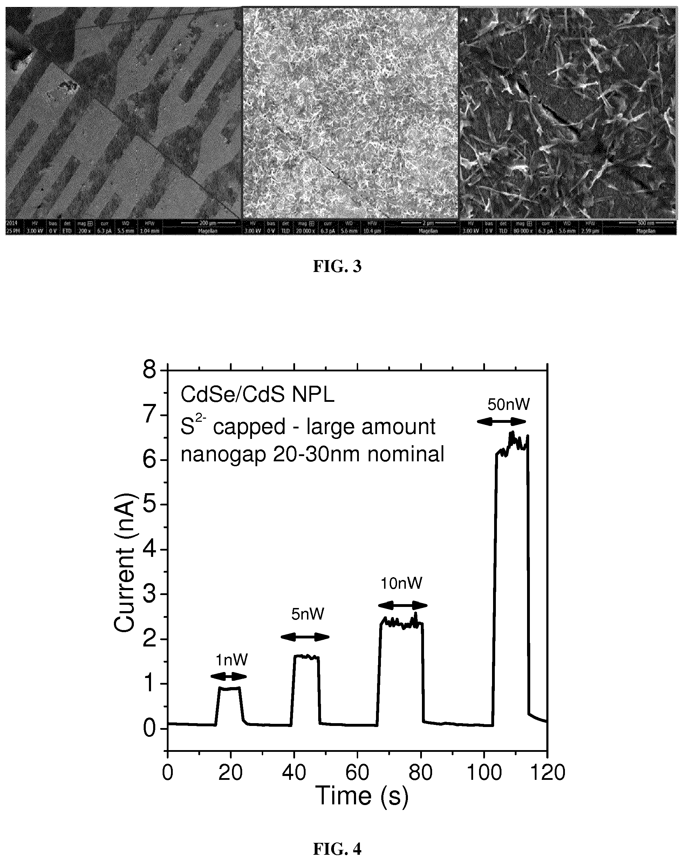

According to an embodiment, as illustrated in figures 1 and 3, several nanoparticles bridge the at least two electrodes spaced by a nanogap (for example 1, 2, 3, 4, 5, 6, 7, 8, 9, 10, $10^2$, $10^3$, $10^4$, $10^5$, $10^6$, $10^7$, $10^{10}$, $10^{15}$, $10^{20}$, $10^{23}$ nanoparticles).

According to an embodiment, at least 2 nanoparticles bridge the at least two electrodes spaced by a nanogap. According to an embodiment, at least 3, 4, 5, 6, 7, 8, 9, 10, $10^2$, $10^3$, $10^4$, $10^5$, $10^6$, $10^7$, $10^{10}$, $10^{15}$, $10^{20}$ or $10^{23}$ nanoparticles bridge the at least two electrodes spaced by a nanogap.

According to an embodiment, a film of nanoparticles, such as a film of nanoplatelets, bridges the at least two electrodes spaced by a nanogap. According to an embodiment, the film of nanoparticle bridging the at least two electrodes spaced by a nanogap has a thickness ranging from 0.1 nm to 100 $\mu$m, preferably ranging from 1 nm to 1 $\mu$m and more preferably from 2 nm to 200 nm.

According to an embodiment, the active material comprising at least one nanoparticle is implemented into a film of nanoparticles. According to an embodiment, the film of nanoparticles is obtained from colloidal nanoparticles. According to an embodiment, the active material does not comprise a film of nanoparticles.

According to the invention, the at least one nanoparticle of the invention is inorganic. According to one embodiment, the at least one nanoparticle of the invention is colloidal and/or crystalline.

According to the invention, the at least one nanoparticle comprises a material selected from Ge, HgS, HgSe, HgTe, PbS, PbSe, PbTe, $CuInS_2$, $CuInSe_2$, $AgInS_2$, $AgInSe_2$, . According to one embodiment, it may be alloys and mixtures thereof.

According to a preferred embodiment, the at least one nanoparticle is selected in the group comprising: HgTe, PbSe, PbS, PbTe and the core/shell structures such as PbS/CdS, PbSe/CdS.

According to an embodiment, the at least one nanoparticle bridging the at least two electrodes spaced by a nanogap has an alloy - such as HgCdTe -, a gradient, a core shell or core-crown structure.

According to an embodiment, the at least one nanoparticle presents a heterostructure, which means that the at least one nanoparticle of the invention is partially coated by at least one layer of inorganic material.

According to an embodiment, the at least one nanoparticle has a core/shell structure, i.e. the core is totally coated by at least one layer of inorganic material.

According to another embodiment, the at least one nanoparticle comprises a core totally coated by a first layer of inorganic material, said first layer being partially or totally surrounded by at least one further layer of inorganic material.

According to an embodiment, the core and the at least one layer of inorganic material are composed of the same material or are composed of different materials.

According to an embodiment, the core and the at least one layer of inorganic material comprise a semiconductor from group IV, group IIIA-VA, group IIA-VIA, group IIIA-VIA, group IA-IIIA-VIA, group IIA-VA, group IVA-VIA, group VIB-VIA, group VB-VIA, or group IVB-VIA.

According to an embodiment, the core and the at least one layer of inorganic material comprise a material $M_xE_y$, wherein:

M is selected from Zn, Cd, Hg, Cu, Ag, Al, Ga, In, Si, Sn, Ge, Pb, Sb, Pd, Fe, Au, Ti, Bi, W, Mo, V or a mixture thereof;
E is selected from O, S, Se, Te, N, P, As or a mixture thereof; and
x and y are independently a decimal number from 0 to 5, at the condition that when x is 0, y is not 0 and inversely.

According to an embodiment, the material $M_xE_y$ comprises cationic element M and anionic element E in stoichiometric ratio, said stoichiometric ratio being characterized by values of x and y corresponding to absolute values of mean oxidation number of elements E and M respectively.

According to an embodiment, the core and the at least one layer of inorganic material comprise a material $M_xN_yE_z$, wherein:

M is selected from Zn, Cd, Hg, Cu, Ag, Al, Ga, In, Si, Sn, Ge, Pb, Sb, Sn, Pd, Fe, Au, Ti, Bi, W, Mo, V or a mixture thereof;
N is selected from Zn, Cd, Hg, Cu, Ag, Al, Ga, In, Si, Sn, Ge, Pb, Sb, Sn, Pd, Fe, Au, Ti, Bi, W, Mo, V or a mixture thereof;
E is selected from O, S, Se, Te, N, P, As or a mixture thereof; and
x, y and z are independently a decimal number from 0 to 5, at the condition that when x is 0, y and z are not 0, when y is 0, x and z are not 0 and when z is 0, x and y are not 0.

According to one embodiment the core and the at least one layer of inorganic material is made of a quaternary compound such as InAlGaAs, ZnAgInSe or GaInAsSb.

According to an embodiment, the core and the at least one layer of inorganic material comprise a material selected from Si, Sn, Ge, Sn, CdS, CdSe, CdTe, ZnS, ZnSe, ZnTe, HgS, HgSe, HgTe, PbS, PbSe, PbTe, $CuInS_2$, $CuInSe_2$, $AgInS_2$, $AgInSe_2$, CuS, $Cu_2S$, $Ag_2S$, $Ag_2Se$, $Ag_2Te$, InN, InP, InAs, InSb, $In_2S_3$, $Cd_3P_2$, $Zn_3P_2$, $Cd_3As_2$, $Zn_3As_2$, ZnO, AlN, AlP, AlAs, AlSb, GaN, GaP, GaAs, GaSb, $FeS_2$, $TiO_2$, $Bi_2S_3$, $Bi_2Se_3$, $Bi_2Te_3$, $MoS_2$, $WS_2$, $VO_2$, and alloys and mixtures thereof.

According to an embodiment, the at least one nanoparticle is oriented with respect to the at least two electrodes spaced by a nanogap. According to an embodiment, the at least one nanoparticle is not randomly arranged on the nanogap electrodes. According to an embodiment, the at least one nanoparticle is randomly arranged on the nanogap electrodes.

According to an embodiment, the at least one nanoparticle bridging the at least two electrodes spaced by a nanogap has a size equal to the nanogap size. According to an embodiment, the at least one nanoparticle bridging the at least two electrodes spaced by a nanogap has a size larger than the nanogap size.

According to an embodiment, the at least one nanoparticle bridging the at least two electrodes spaced by a nanogap has a size of at least 10nm, preferably at least 15 nm, more preferably at least 30 nm. According to an embodiment, the at least one nanoparticle bridging the at least two electrodes spaced by a nanogap has a size ranging from about 0.1 nm to about 1 000 nm, preferably from about 1 nm to about 200 nm, more preferably from about 5 nm to about 100 nm, even more preferably from about 10 nm to about 75 nm.

According to an embodiment, the at least one nanoparticle is further coated by an organic capping, agent, an inorganic capping agent, or mixture thereof. According to an embodiment, the at least one nanoparticle has a surface chemistry made of organic ligand such as for example an alkyl chain connected to a thiol, amine, acid and/or phosphine function.

According to an embodiment, the at least one nanoparticle has a surface chemistry made of ions such as $S^{2-}$, $OH^-$, $HS^-$, $Se^{2-}$, $NH^{2-}$, $Te^{2-}$, $SCN^-$, $Br^-$, $I^-$, $Cd^{2+}$, $NH_4^+$, $Hg^{2+}$, $Cl^-$, $Zn^{2+}$, $Pb^{2+}$, or mixture thereof.

According to an embodiment, the at least one nanoparticle has a surface chemistry made metal chalcogenides.

According to an embodiment, the at least one nanoparticle is not selected from carbon based nanoparticle such as carbon nanotubes (multi-walled or single-walled) or graphene. According to an embodiment, the at least one nanoparticle is not selected from silver nanoparticle. According to an embodiment, the at least one nanoparticle is not selected from silicon nanoparticle. According to an embodiment, the at least one nanoparticle is not selected from aluminum nanoparticles, preferably not selected from aluminum quantum dot. According to an embodiment, the at least one nanoparticle does not comprise a semiconductor selected from group III-V, more preferably the at least one nanoparticle is not selected from GaAs.

According to an embodiment, the at least one nanoplatelet is not prepared by exfoliation of the corresponding layered bulk crystals.

According to an embodiment, the electronic device of the present invention does not comprise a nitrogenous material disposed or coated on the at least one nanoparticle.

According to an embodiment, the electronic device of the present invention does not comprise composite made of semiconductor material and plasmonic nanoparticles.

According to an embodiment, the nanogap accommodates biological or chemical molecules. According to an embodiment, the nanogap does not accommodate biological or chemical molecules.

According to an embodiment, the nanogap does not accommodate at least one nanoparticle; the at least one nanoparticle bridges the at least two electrodes spaced by a nanogap.

According to an embodiment, the at least one nanoparticle is not positioned between the at least two electrodes spaced by a nanogap; the at least one nanoparticle bridges the at least two electrodes spaced by a nanogap.

According to an embodiment, the nanoparticle bridging the nanotrench covered at least 5%, at least 10%, at least 25%, at least 30%, at least 40%, at least 50%, at least 75%, at least 80%, at least 90% or about 100% of the nanotrench area.

According to an embodiment, the at least one nanoparticle does not comprise a bridging molecule.

According to an embodiment, the nanotrench contains more than 1 bridging nanoparticle, more preferably more than 2 bridging nanoparticles, more preferably more than 5 bridging nanoparticles, more preferably more than 10 bridging nanoparticles and even more preferably more than 100 bridging nanoparticles.

According to an embodiment, the electronic device of the invention is not used to conduct tunnel spectroscopy.

According to an embodiment, the nanotrench contains more than 2 bridging nanoparticles, and is not used to conduct tunnel spectroscopy.

According to an embodiment, the nanoparticles have absorption and/or photoconduction properties in the X ray and/or in the UV and/or in the visible and/or in the infrared.

According to an embodiment, the nanoparticles have absorption and/or photoconduction properties in the near infrared, and/or in the mid infrared and/or in the long wavelength infrared and/or in the far infrared and or in the THz.

According to an embodiment, the nanoparticles have absorption and/or photoconduction properties from about 750 nanometers to about 1 000 000 nanometers, preferably from about 750 nanometers to about 50 000 nanometers, more preferably from about 750 nanometers to about 10 000 nanometers.

According to an embodiment, the nanoparticles are not metallic nanoparticles.

According to an embodiment, the nanoparticles are semiconductor nanoparticles.

According to an embodiment, the electronic device of the present invention comprises at least one electrolyte: electrolyte gating is performed to tune the carrier density of the at least one nanoparticle bridging the at least two electrodes spaced by a nanogap.

According to an embodiment, solid, polymer, gel, ion-gel or liquid electrolytes may be implemented, preferably gel or solid electrolytes.

According to an embodiment, the contact between the electrolyte and the nanogap electrodes is prevented by the active material (i.e. by the at least one nanoparticle).

According to an embodiment, the contact between the electrolyte and the first and second electrodes is prevented by the active material (i.e. by the at least one nanoparticle).

According to an embodiment, the electrolyte can be in the form of an aqueous solution of a dissolved ionic chemical compound (or compounds), a non-aqueous solution of a dissolved ionic chemical compound (or compounds), a polymer electrolyte, a gel electrolyte, a solid electrolyte or a molten salt electrolyte.

According to an embodiment, the electrolyte comprises a matrix and ions. According to a preferred embodiment, the electrolyte comprises a polymer matrix.

According to an embodiment, the polymer matrix of the electrolyte comprises polystyrene, poly(N-isopropyl acrylamide), polyethylene glycol, polyethylene, polybutadiene, polyisoprene, polyethylene oxide, polyethyleneimine, polymethylmethacrylate, polyethylacrylate, polyvinylpyrrolidone, polypropylene glycol, polydimethylsiloxane, polyisobutylene, or a blend/multiblocks polymer thereof.

According to an embodiment, the electrolyte comprises ions salts. According to an embodiment, the polymer matrix is doped with ions salts. According to said embodiments, the ions salts is LiCl, LiBr, LiI, LiSCN, $LiClO_4$, $KClO_4$, $NaClO_4$, $ZnCl_3^-$, $ZnCl_4^{2-}$, ZnBr2, $LiCF_3SO_3$, $LiPF_6$, $LiAsF_6$, $LiN(SO_2CF_3)_2$, $LiC(SO_2CF_3)_2$, $LiBF_4$, $NaBPh_4$, NaCl, NaI, NaBr, NaSCN, KCl,, KBr, KI, KSCN, $LiN(CF_3SO_2)_2$, or mixture thereof.

According to an embodiment, the electrolyte comprises material that contains mobile ions of lithium, sodium, potassium, ammonium, hydrogen, copper, silver or mixture thereof.

According to an embodiment, the electrolyte comprises polymers and/or glasses, including but not limited to PEG, PEO, PVDF, PET, PTFE, FEP, FPA, PVC, polyurethane, polyester, silicone, some epoxies, polypropylene, polyimide, polycarbonate, polyphenylene oxide, polysulfone, calcium magnesium aluminosilicate glasses, E-glass, alumino-borosilicate glass, D-glass, borosilicate glass, silicon dioxide, quartz, fused quartz, silicon nitride, silicon oxynitride, or mixture thereof.

According to an embodiment, the electrolyte comprises ionic liquid. According to an embodiment, the polymer matrix and the ions are replaced by a polymerizable ionic liquid.

According to an embodiment, the at least one nanoparticle surface chemistry is chosen to be a counterion of one of the ions of the electrolyte.

According to an embodiment, the nanoparticle surface chemistry is chosen so that the at least one nanoparticle and the electrolyte can form a redox reaction.

According to an embodiment, at least one ion from the electrolyte can reversibly give one or more electron(s) to the active material (i.e. the at least one nanoparticle) as in redox based reactions.

Examples of pairs of nanoparticle surface chemistry/ion include but is not limited to: $OH^-/Li^+$, $OH^-/Na^+$, $OH^-/K^+$, $OH^-/NH_4^+$, $OH^-/$any ammonium ion, $OH^-/$any ionic liquid, $O^{2-}/Li^+$, $O^{2-}/Na^+$, $O^{2-}/K^+$, $O^{2-}/NH_4^+$, $O^{2-}/$any ammonium ion, $O^{2-}/$any ionic liquid, $HS^-/Li^+$, $HS^-/Na^+$, $HS^-/K^+$, $HS^-/NH_4^+$, $HS^-/$any ammonium ion, $HS^-/$any ionic liquid, $SCN^-/Li^+$, $SCN^-/Na^+$, $SCN^-/K^+$, $SCN^-/NH_4^+$, $SCN^-/$any ammonium ion, $SCN^-/$any ionic liquid, $NH_2^-/Li^+$, $NH2^-/Na^+$, $NH_2^-/K^+$, $NH_2^-/NH_4^+$, $NH_2^-/$any ammonium ion, $NH_2^-/$any ionic liquid, $S^{2-}/Li^+$, $S^{2-}/Na^+$, $S^{2-}/K^+$, $S^{2-}/NH_4^+$, $S^{2-}/$any ammonium ion, $S^{2-}/$any ionic liquid, $Se^{2-}/Li^+$, $Se^{2-}/Na^+$, $Se^{2-}/K^+$, $Se^{2-}/NH_4^+$, $S_e^{2-}/$any ammonium ion, $S_e^{2-}/$any ionic liquid, $Te^{2-}/Li^+$, $T_e^{2-}/Na^+$, $Te^{2-}/K^+$, $Te^{2-}/NH_4^+$, $Te^{2-}/$any ammonium ion, $Te^{2-}/$any ionic liquid, $Cl^-/Li^+$, $Cl^-/Na^+$, $Cl^-/K^+$, $Cl^-/NH_4^+$, $Cl^-/$any ammonium ion, $Cl^-/$any ionic liquid, $Br^-/Li^+$, $Br^-/Na^+$, $Br^-/K^+$, $Br^-/NH_4^+$, $Br^-/$any ammonium ion, $Br^-/$any ionic liquid, $I^-/Li^+$, $I^-/Na^+$, $I^-/K^+$, $I^-/NH_4^+$, $I^-/$any ammonium ion, $I^-/$any ionic liquid, any metal-chalcogenide/ $Li^+$, any metal-chalcogenide /$Na^+$, any metal-chalcogenide /$K^+$, any metal-chalcogenide /$NH_4^+$, any metal-chalcogenide /any ammonium ion, any metal-chalcogenide /any ionic liquid, $Cd^{2+}/Cl^-$, $Cd^{2+}/Br^-$, $Cd^{2+}/I^-$, $Cd^{2+}/SO_4^{2-}$, $Cd^{2+}/ClO_4^-$, $Cd^{2+}/BF_4^-$, $Cd^{2+}/NO_3^-$, $Cd^{2+}/$ any ionic liquid, $Pb^{2+}/Cl^-$, $Pb^{2+}/Br^-$, $Pb^{2+}/I^-$, $Pb^{2+}/SO_4^{2-}$, $Pb^{2+}/ClO_4^-$, $Pb^{2+}/BF_4^-$, $Pb^{2+}/NO_3^-$, $Pb^{2+}/$ any ionic liquid, $Zn^{2+}/Cl^-$, $Zn^{2+}/Br^-$, $Zn^{2+}/I^-$, $Zn^{2+}/SO_4^{2-}$, $Zn^{2+}/ClO_4^-$, $Zn^{2+}/BF_4^-$, $Zn^{2+}/NO_3^-$, $Zn^{2+}/$ any ionic liquid, $Hg^{2+}/Cl^-$, $Hg^{2+}/Br^-$, $Hg^{2+}/I^-$, $Hg^{2+}/SO4^{2-}$, $Hg^{2+}/ClO_4^-$, $Hg^{2+}/BF_4^-$, $Hg^{2+}/NO_3^-$, $Hg^{2+}/$any ionic liquid, $NH_3^+/Cl^-$, $NH_3^+/Br^-$, $NH_3^+/I^-$, $NH_3^+/SO4^{2-}$, $NH_3^+/ClO_4^-$, $NH_3^+/BF_4^-$, $NH_3^+/NO_3^-$, $NH_3^+/$any ionic liquid.

According to an embodiment, the electrolyte is transparent in a wavelength window compatible with the absorption spectrum of the at least one nanoparticle. Compatible means herein that the substrate is at least partly transparent in the range of wavelength wherein the at least one nanoparticle is absorbing. Partly transparent means herein that the substrate has a transmittance of at least 50%, preferably at least 75%, more preferably at least 90%.

According to an embodiment, the electrolyte is transparent in the visible, i.e. in a wavelength range from about 380 nanometers to about 750 nanometers.

According to an embodiment, the electrolyte is transparent in the ultraviolet range of wavelength, i.e. in a wavelength range from about 10 nanometers to about 380 nanometers.

According to an embodiment, the electrolyte is transparent in the infrared range of wavelength, i.e. in the wavelength range from about 750 nanometers to about 1 000 000 nanometers, preferably from about 750 nanometers to about 50 000 nanometers, more preferably from about 750 nanometers to about 3 000 nanometers.

According to an embodiment, the electrolyte transparency window is at least 1 nm large, preferably at least 10 nm large and more preferably above 50 nm large.

According to one embodiment, the substrate is partly transparent in the visible and/or in the ultraviolet range of wavelength and/or in the infrared range of wavelength.

According to an embodiment, the electrolyte is transparent in two wavelength windows compatible with the absorption spectrum of the at least one plurality of nanoparticle.

According to an embodiment, the electrolyte transparency window is made of several windows in order to fit the absorption spectrum of the multicolor detector, preferably of several narrow transparency windows i.e. of at most 50 nm large.

According to one embodiment, the nanogap has an aspect ratio $L/d$ ranging from 1 to $10^9$, from 100 to $10^9$, from 200 to $10^9$, from 500 to $10^9$, from 1 000 to $10^9$, from 10 000 to $10^9$, from 10 to $10^8$, from 100 to $10^7$, from 1 000 to $10^7$, from 10 to $10^6$, or from 100 to $10^5$; in addition, at least 1, 2, 3, 4, 5, 6, 7, 8, 9, 10, $10^2$, $10^3$, $10^4$, $10^5$, $10^6$, $10^7$, $10^{10}$, $10^{15}$, $10^{20}$, $10^{23}$ nanoparticles bridge the at least two electrodes spaced by a nanogap and said nanoparticle bridging the nanogap covers at least 5%, at least 10%, at least 25%, at least 30%, at least 40%, at least 50%, at least 75%, at least 80%, at least 90% or about 100% of the nanogap area.

The manufacturing process for preparing the electronic device of the present invention comprises two main steps:

- nanogap electrodes fabrication,
- deposition of the at least one nanoparticle onto the nanogap and nanoparticle's ligand exchange after or before deposition on the nanogap, and
- optionally, electrolyte deposition.

More precisely, the manufacturing process for preparing the electronic device of the present invention comprises:

a) the fabrication of the at least two electrodes spaced by a nanogap onto a substrate,
b) the preparation of colloidal nanoparticles,
b') optionally, the nanoparticle's ligand exchange step in solution,
c) the deposition of at least one nanoparticle onto the nanogap wherein the at least one nanoparticle has an overlap area with the at least two electrodes spaced by a nanogap higher than 5% of the area of the at least one nanoparticle,
c') if step b') is not implemented, nanoparticle's ligand exchange step,
d) optionally, the electrolyte deposition on the active material (i.e. on the at least on nanoparticle), and
e) optionally, the deposition of a further electrode on the electrolyte.

According to an embodiment, the steps b), b'), c), c') may be implemented more than once with different nanoparticles.

According to an embodiment, the at least two electrodes of step a) are at least a source and a drain electrodes and the further electrode of step e) is a gate electrode.

According to one embodiment, the at least two electrodes are processed with a gas treatment before step c).

According to one embodiment, the at least two electrodes are treated with molecules such as short-chain alkane thiols to improve the adhesion of the at least one nanoparticle before step c).

According to one embodiment, the at least two electrodes are treated with a coating for passivating the surface of the at least two electrodes before step c).

According to an embodiment, the at least two electrodes are annealed before step c) at a temperature ranging from 100°C to 1 000°C.

According to an embodiment, the component in progress is annealed before step d) at low temperature, typically below 400° C, or below 300° C, or below 200° C, or below 100° C.

According to one embodiment, the at least one nanoparticle bridging the nanogap electrodes is obtained by a process which fuses smaller nanoparticles, such as a chemical process or an annealing step.

According to one embodiment, the nanogap bridged by at least one nanoparticle is exposed to an atomic layer deposition or a chemical bath deposition step.

According to an embodiment, for narrow band gap material, nanoparticle's ligand exchange is performed, after deposition, in the active material comprising at least one nanoparticle or on the nanoparticles in solution prior to the deposition of at least one nanoparticle, preferably, after deposition, in the active material comprising at least one nanoparticle.

According to an embodiment, the film of nanoparticle can be treated with a ligand exchange procedure made on the film of nanoparticle. A solution of short ligand such as ethanedithiol for example at 1% in volume in ethanol is prepared. The nanoparticles, capped with their long ligand as from the synthesis, under a film form are dipped for 30s in the short ligand solution and finally rinsed in pure solvent such as alcohol or acetonitrile.

According to an embodiment, the nanoparticle can be treated with a ligand exchange procedure directly on the solution. A solution of ions such as $S^{2-}$ or $Cl^-$ for example is prepared at 1% in mass in polar solvent such as N methyl formamide. This solution is mixed with the nanoparticle in non-polar solvent such as toluene or hexane. The two phases are strongly mixed and sonicated.

A phase transfer occurs and the nanoparticles get capped with the short ligand and dispersed in the polar phase. This solution can now be directly used to build conductive device.

According to an embodiment, for wide band gap material nanoparticle's ligand exchange is performed, after deposition, in the active material comprising at least one nanoparticle or on the nanoparticles in solution prior to the deposition of at least one nanoparticle, preferably on the nanoparticles in solution prior to the deposition.

According to an embodiment, nanoparticle's ligand exchange improves the conduction properties of the active material.

According to an embodiment, the method of fabrication of the nanogap electrodes is selected from electromigration, electrodeposition, mechanically controlled break junctions, e-beam lithography methods, self-alignment methods, lift-off methods, shadowing methods, on-wire lithography, nanotube masks.

According to an embodiment, the at least one nanoparticle bridging the at least two electrodes spaced by a nanogap is deposited using conventional deposition techniques, including for example, drop casting, spin coating, dip coating, spray casting, inkjet printing, screen printing, sputtering techniques, evaporation techniques, electrophoretic deposition, vacuum methods, gravure printing, flexographic printing or any other means that a person skilled in the art would find appropriate.

According to an embodiment, the at least two electrodes spaced by a nanogap are made of the same material.

According to an embodiment, the at least two electrodes spaced by a nanogap are made of gold.

According to an embodiment, the at least two electrodes spaced by a nanogap are made of Au, Ag, Ti, Cr, Pd, Pt, Cu, Ni, Al, Fe and their alloy.

According to an embodiment, the at least two electrodes spaced by a nanogap are made of Si, Ge, GaAs, InP and their alloy.

According to an embodiment, each electrode composing the nanogap can be made with a layered structure such as Ti/Au.

According to an embodiment, each electrode composing the nanogap includes a layer which role is to favor the contact of the top material onto the substrate. This layer is typically made of Ti or Cr.

According to an embodiment, the thickness of each electrode ranges from 1 nm to 1 mm, more preferably from 30 nm to 1 $\mu$m.

According to an embodiment, the at least two electrodes spaced by a nanogap are made of different materials.

According to an embodiment, the at least two electrodes spaced by a nanogap are made of two different materials such as Al/Pt, Al/Au, Ag/Au, Ag/Pt.

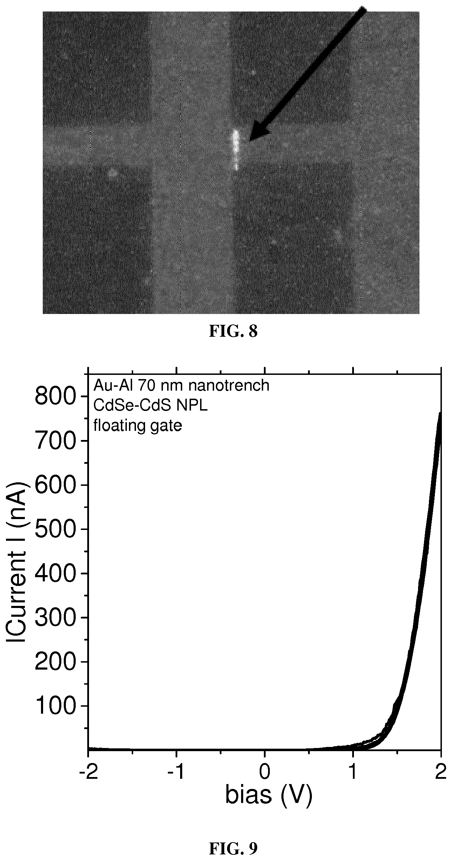

According to an embodiment, the device made of two asymetric electrodes presents a diode behavior (asymetric IV curve), see figure 9.

According to an embodiment, the electrolyte is deposited using any printing methods that a person skilled in the art would find appropriate, such as for example spin coating or dip coating, or drop casting.

According to an embodiment, in use, the bias applied between the at least two electrodes spaced by a nanogap is below 100 V, preferably below 10 V, more preferably below 5 V.

According to an embodiment, in use, the current flowing between the at least two electrodes spaced by a nanogap is ranging from 1 fA to 1 A, preferably from 1 pA to 1 mA.

According to an embodiment, the device is operated in air. According to an embodiment, the device is operated under inert atmosphere. According to an embodiment, the device is operated under vacuum.

According to an embodiment, the device is operated at a temperature ranging from 0 K to 400 K, preferably from 4 K to 350 K, more preferably from 77 K to 300 K.

According to an embodiment, using nanogap based electrodes bridged by nanoparticles, especially by nanoplatelets, instead of conventional micrometric spaced electrodes unexpectedly improves the responsivity performance.

According to an embodiment, the electronic device of the present invention has a responsivity ranging from 1 $A.W^{-1}$ to $10^9$ $A.W^{-1}$, from 1 $A.W^{-1}$ to $10^8$ $A.W^{-1}$, from 1 $A.W^{-1}$ to $10^7$ $A.W^{-1}$, from 1 $A.W^{-1}$ to $10^6$ $A.W^{-1}$, preferably from 1 $A.W^{-1}$ to $10^5$ $A.W^{-1}$, more preferably from 1 $A.W^{-1}$ to $10^4$ $A.W^{-1}$, even more preferably from 100 $A.W^{-1}$ to 5 000 $A.W^{-1}$.

According to an embodiment, the electronic device of the present invention has a responsivity of at least 1 $A.W^{-1}$, preferably at least to 20 $A.W^{-1}$, more preferably at least 50 $A.W^{-1}$, even more preferably at least 100 $A.W^{-1}$.

According to an embodiment, the electronic device of the present invention has an electron mobility ranging from $10^{-6}$ $cm^2V^{-1}s^{-1}$ to $10^4$ $cm^2v^{-1}s^{-1}$, preferably from $10^{-2}$ $cm^2v^{-1}s^{-1}$ to $10^3$ $cm^2v^{-1}s^{-1}$.

According to an embodiment, the electronic device of the present invention has a specific detectivity of at least $10^7$ $cm.Hz^{1/2}W^{-1}$ (also called "Jones"), preferably at least $10^{10}$ Jones, more preferably at least $10^{12}$ Jones, even more preferably at least $10^{13}$ Jones.

According to an embodiment, the electronic device of the present invention has a response time smaller than 100 milliseconds, preferably smaller than 10 milliseconds, more preferably smaller than 0.1 milliseconds, even more preferably smaller than 0.01 milliseconds.

According to an embodiment, the device of the present invention can also be attractive for other application than photoconduction: thanks to the small gap it is very easy to apply a very large bias ($10^8$ $V.m^{-1}$ can easily be obtained). This large electric field can be used to obtain Stark effect in the bridging nanoparticle. Indeed under an applied electric field the quantum state tend to be shifted in energy. In particular a shift and a bleach of the optical feature are expected. This effect can be used to build an optical modulator.

According to an embodiment, the electronic device of the present invention is used in biological imaging, photodetectors, photovoltaic devices, transistors, stark modulators, light emission devices, quantum-dot lasers, or solar cells.

According to an embodiment, the device is used as optical modulator.

According to an embodiment, the device is used as photodetector.

According to an embodiment, the device is used as single pixel photodetector.

According to an embodiment, several devices (i.e. several nanogaps) are used to build a several pixels detector.

According to an embodiment, are used to build an array of detecting pixel used for instance as a focal plane array.

According to an embodiment, the device is not used as a switch.

In one embodiment the gate electrode is grounded and a source and drain bias with different sign is applied.

In one embodiment the gate electrode is grounded and a pn junction is formed between the drain and source nanogap electrodes.

In one embodiment, a pn junction is formed between two of the nanogap electrodes and this electronic device may be used as a LED or as a photodetector operating in photovoltaic mode.

According to an embodiment, the device used as photodetector is operated in the visible range of wavelength. According to another embodiment, the device used as photodetector is operated in the infrared range of wavelength. According to another embodiment, the device used as photodetector is operated in the ultraviolet range of wavelength. According to another embodiment, the device used as photodetector is operated in the X-ray range of wavelength.

According to an embodiment, the device is used to form a diode. According to an embodiment, the device is used for manufacturing an electrical diode.

According to an embodiment, the device used as a diode is the active element of a photovoltaic solar cell. According to an embodiment, the device is used for manufacturing a photovoltaic solar cell or an electroluminescent component.

According to an embodiment, the device used as a diode is the active element of a light emitting diode.

According to an embodiment, the device used as a light emitting diode is the component of a lighting device.

According to an embodiment, the device used as a light emitting diode is the component of a display.

According to an embodiment, the device is used as transistor. According to an embodiment, the device is used as phototransistor.

According to an embodiment, the device is used as a nonlinear component of an electrical circuit.

According to an embodiment, the device is used as a chemical sensor. According to an embodiment, the chemical sensitivity of the device is obtained by the presence of the detecting element acting as a dopant. According to an embodiment, the device used as a chemical sensor is sensitive to the concentration of a species diluted in a solvent used as electrolyte. According to an embodiment, the device used as a chemical sensor presents some selectivity properties related to the surface chemistry of the at least one nanoparticle used to bridge the at least two electrodes spaced by a nanogap.

According to an embodiment, the device is used to obtain electroluminescence from the at least one nanoparticle bridging the at least two electrodes spaced by a nanogap.

According to an embodiment, the device is used to obtain stimulated light emission from the at least one nanoparticle bridging the at least two electrodes spaced by a nanogap.

According to an embodiment, the device is as a gain material of a laser.

It should be understood that the spatial descriptions (e.g., "above", "below", "up", "down", "top", "bottom", "on", "under", etc.) made herein are for purposes of illustration only, and that devices of the present invention can be spatially arranged in any orientation or manner that one skilled in the art could easily implemented.

## BRIEF DESCRIPTION OF THE DRAWINGS

Figure 1 is a scheme of the electronic device according to one embodiment of the present invention.

Figure 2 is a scanning electron microscopy picture of nanogaps at three different scales.

Figure 3 is a scanning electron microscopy picture of nanogaps coated with CdTe nanoplatelets at three different scales.

Figure 4 shows the current as a function of time under a constant drain-source bias in the electronic device according to a reference example wherein the nanogap electrodes are bridged with CdSe/CdS nanoplatelets. The square response corresponds to light illumination. The response time of the electronic device is faster than 0.1 second.

Figure 5 shows the current as a function of drain bias under incident light power in the electronic device according to a reference example wherein the nanogap electrodes are bridged with CdSe/CdS nanoplatelets.

Figure 6 shows the current as a function of gate bias under incident light power in the electronic device according to a reference example wherein the nanogap electrodes are bridged with CdSe/CdS nanoplatelets. The gating is made by $LiClO_4$ in PEG as electrolyte.

Figure 7a is a scheme of the energy diagram of the electronic device according to a reference example under zero drain bias for conduction and valence band.

Figure 7b is a scheme of the conduction band diagram of the electronic device according to a reference example under different drain bias.

Figure 8 is an image of a nanogap and the electroluminescent signal (indicated by the arrow) located at the nanotrench level.

Figure 9 represents the current vs voltage for a nanogap made of Au and Al contact spaced by 70 nm and connected using CdSe/CdS Nanoplatelets.

## REFERENCES

**N**    Nanoparticle(s)
**E**    Electrode(s)
**d**    Nanogap size - Inter-electrode distance
**L**    Nanogap length - Length of the electrode

## EXAMPLES

The present invention is further illustrated by the following examples.

Nanoparticle synthesis:

- *CdSe nanoplatelets (not falling in the scope of the claims)*

In a first step Cadmium myristate ($Cd(Myr)_2$) is prepared. In a typical synthesis 240 mg of $Cd(Myr)_2$, 25 mg Se powder are mixed in 30ml of ODE, the solution degased under vacuum for 20 minutes at room temperature. Then the atmosphere is switch to Argon and the temperature is set to 240° C. At 204° C 40 mg of $Cd(OAc)_2$ are quickly added. The reaction is performed 12 minutes at 240° C. After this, the solution is cooled down. The precipitation of the nanoplatelets is done by adding ethanol. After centrifugation the obtained solid is redispersed in hexane. The cleaning procedure is repeated three times.

■ *CdTe nanoplatelets (not falling in the scope of the claims)*

In a first step Cadmium propanoate (Cd(Prop)$_2$) is prepared by mixing 1.036 g of CdO in 10 ml of propionic acid under Argon for 1 hour. Then the flask is open to air and the temperature risen to 140° C up to the point the volume get divided by a factor two. The whitish solution is precipitated by addition of acetone. After centrifugation the solid is dried under vacuum for 24 hours. In the glove box 1M TOPTe is prepared by stirring 2.55 g of Te pellets in 20 ml of TOP for four days at room temperature. In a three necks flask 0.13 g of Cd(Prop)$_2$, 160 $\mu$m of oleic acid and 10 ml ODE are degased for 90 minutes at 95°C. Then the atmosphere is switched to Argon and the temperature risen to 210° C. 0.2 mL of 1M TOPTe is quickly injected in the flask. After 20 minutes the reaction is quenched by adding 1 mL of oleic acid and cooling down the flask at room temperature. The cleaning process is done by adding Ethanol to precipitate the CdTe nanoplatelets. The solid obtained after centrifugation is redispersed in hexane. This procedure is repeated three times.

■ *CdSe/CdS nanoplatelets (not falling in the scope of the claims)*

Two procedures can be performed to obtain a CdS shell on CdSe core. In a first procedure 30 mg of NaSH are mixed in 4 ml of N methyl formamide (NMFA) in a 20 mL vial up to dissolution. Then 500 $\mu$L of the CdSe core in solution in hexane are added in the vial. The solution is stirred until a complete transfer of the nanoparticles in the nmFA phase. Then 500 $\mu$l of 0.2 M cadmium acetate in nmFA are added in the vial. The reaction is performed for 1hour at room temperature under stirring. Precipitation is ensured by addition of ethanol. After centrifugation the obtained solid is dispersed in nmFA. The cleaning step is repeated a second time. As an alternative procedure to grow the shell it is possible to dissolve 30mg of Na$_2$S are mixed in 2 ml of nmFA in a 4 mL vial up to dissolution. The core are then precipitated by addition of acetonitrile to remove the excess of sulfide and redispersed in nmFA. Then 500 $\mu$l of 0.2 M cadmium acetate in nmFA are added in the vial. After the almost immediate reaction the excess of precursors is removed by precipitation of the nanocrystals with a mixture of toluene and acetonitrile (5:1). The solid obtained by centrifugation is redisolved in nmFA. The procedure is repeated 3.5 times. The final nanoparticles are stored in nmFA.

■ *Spherical CdSe quantum dots (not falling in the scope of the claims)*

In a three necks flask, 8 ml of ODE, 1.5 g of TOPO and 0.75 ml of Cd(OA)$_2$ at 0.5 M in oleic acid are degased for 30 minutes under vacuum. Then under argon flow, the temperature is set at 280° C and a mixture of 3 ml of oleylamine and 4 ml of TOPSe at 1 M in TOP are quickly injected at 300° C while the temperature is set at 280° C. After 8 minutes, the reaction is stopped and the quantum dots are precipitated twice with ethanol and resuspended in hexane.

■ *PbS spherical quantum dots (not falling in the scope of the claims)*

In a three necks flask, we introduce 0.9 g lead oxide and 40mL of oleic acid. The mixture is degased for 1 h at 100° C under vacuum and then heated under Argon at 150° C for three hours. In the glove box 0.4 mL of Bis(trimethylsilyl)sulfide (TMSS) are mixed in 20 mL of octadecene (ODE). In a 100 mL three necks flask, 12 ml of the lead oleate (PbOA) mixture previously prepared are quickly degased at 100° C and then heated at 150° C under Argon. 6mL of the solution of TMSS in ODE are quickly injected to the flask and the reaction performed for 3 minutes. Finally the solution is quickly cooled to room temperature. The solution is precipitated by adding ethanol and centrifuged for 5 minutes at 3000 rpm. The solid is redispersed in toluene. The cleaning step is repeated a second time. At the third cleaning, selective precipitation is performed to separate the different size.

■ *HgTe spherical quantum dots (not falling in the scope of the claims)*

In the glove box a 1 M solution of trioctylphosphine telluride (TOPTe) is prepared by a slow stirring of Te powder in trioctylphosphine (TOP). In a three neck flask 135 mg of HgCl$_2$ and 7.4 g of octadecylamine are degased under vacuum for 1 hour at 120° C. The atmosphere is then switch to Argon and the solution heated at 80° C. 0,5 ml of the 1 M TOPTe are quickly injected and the reaction is performed at the same temperature for 5 minutes. The solution is quenched by a quick addition of dodecanthiol. Finally the flask is cooled down to room temperature. The obtained dark solution is then split between two centrifuge tubes filled with a 10 % in volume mixture of dodecathiol (DDT) in tetrachloroethylene (TCE) and a droplet of TOP. The solution is precipitated by addition of methanol. After centrifugation the solid is dried and redispersed in chloroform. The cleaning is step is repeated three times.

■ *CdS nanorods (not falling in the scope of the claims)*

In the glove box, 0.18 g of sulfur powder are stirred in 20 ml of TOP up to dissolution and formation of trioctylphosphine sulfide (TOPS). The final solution is reddish. In a 100 ml three necks flask, 0.23 g of CdO, 0.83 g of n-tetradecylphosphonic acid (nTDPA) and 7 g of trioctylphosphine oxide (TOPO) are degased under vacuum for two hours at 80° C. Then the flask is switch under Argon and the temperature risen up to 340° C. Above 300° C the solution turns colorless. After 5 minutes the flask is cooled to 300° C, every two minutes 0.4 ml of the TOPS mixture is injected. The color of the solution turn yellowish after 30 minutes and this color will increase up to the end. Once all the TOPS have been injected the heating mantle is removed and the flask quickly cooled down. Around 70° C some toluene is added to avoid the TOPO solidification. The cleaning process is repeating three times by precipitating the rods by adding ethanol and redispersing them in toluene.

Nanogap fabrication:

■ *Self-aligned method*

On a Si/SiO$_2$ wafer, a first electrode is prepared either using standard optical lithography or electron beam lithography. In a typical preparation AZ 5214-E resist is deposit by spin coating on the wafer. The wafer is then baked for 90 s at 110° C. A first UV exposure using the lithography mask is performed for a couple second. Then the film is further bake at 125° C for 2 minutes. Finally we process to metal deposition. The electrodes are made of a layer of Ti (2nm), a layer of gold (30nm) and a layer of Cr (30nm). Lift off process is then made to remove the resist by dipping the wafer in acetone. The wafer is then cleaned using isopropanol and a plasma O$_2$ etching is conducted for 5 minutes. The electrodes are cooked in air at 250° C for 30 minutes in order to convert the Cr into chromium oxide. In a second step a second electrodes is prepared using the same ligthography method in a geometry which allow an overlap with the first electrode. For metal deposition we evaporate a Ti layer (2nm) and a gold layer (30nm). The chromium oxide layer acts as a shadow mask and a nanometer size gap is formed between the two electrodes. After a lift off step and a cleaning step, the top chromium oxide layer of the first electrodes is etched using a chromium etchant solution. A final step of cleaning with acetone and isopropanol is performed.

■ *E-beam lithography method*

On a Si/SiO$_2$ wafer, a polyemtehyl metacrylate polymer is deposited and cooked at 165° C to remove the excess of solvent. Using electron beam lithography, two electrodes are designed and allows in a second step the evaporation of metals (typically 3 nm of Cr and 30 nm of gold). After a lift off procedure the nanogap is formed.

■ *Tilted evaporation method*

On a Si/SiO$_2$ wafer, a first electrode is prepared either using standard optical lithography or electron beam lithography. In a typical preparation AZ 5214 E resist is deposit by spin coating on the wafer. The wafer is then baked for 90 s at 110° C. A first UV exposure using the lithography mask is performed for a couple second. Then the film is further bake at 125° C for 2 minutes. We then process to metal deposition by evaporating Ti (2 nm) and a layer of gold (30 nm). A second pattern is prepared using the same lithography procedure. The second metallic evaporation is made while the sample is tilted in order that the first electrode shadows some part of the second pattern. This shadow effect allows the formation of nanogap at the scale of a few tenth nanometers.

■ *Nanoparticle ligand exchange and depositions for photodetection - 1$^{st}$ strategy*

The nanoparticles initially dispersed in a non-polar solvent can be spincoated onto the nanogap in a glove box. The film is then heated on a hot plate to remove the excess of solvent at 90° C. The device is then dipped into a solution of short ligand such as ethandithiol ou 1.4 diaminobutane at 1% in ethanol for 1 minute. The film is then rinced in pure ethanol for 20 s and finally dried under nitrogen flow.

■ *Nanoparticle ligand exchange and depositions for photodetection - 2$^{nd}$ strategy*

The nanoparticles initially dispersed in a non-polar solvent are mixed with a solution of Na$_2$S in N-methyl formamide (1% in weight). After strong sonication the particle switch of phase and are transferred in the polar phase. The initial and now clear non polar phase is discarded. The polar phase is then cleaned two other times by adding hexane. The nanoparticles are precipitated by addition of an alcohol. The obtained pellet is redispersed in fresh N-methyl formamide. This solution is then dropcasted onto the nanogap on a hot plate at 100° C. The heating is performed until a complete removal of the solvent.

■ *Electrolyte preparation*

The electrolyte is a mixture of polyethylene glycol (PEG) or polyethylene oxide (PEO) with a given molar weight and ions. The molar ratio between the cation and the oxygen is taken equal to 16. For a typical electrolyte 50 mg of LiClO$_4$ and 230 mg of PEG (MW=6000 g.mol$^{-1}$) are heated together at 150° C on a hot plate in the glove box. For higher PEG/PEO molar weight the mixture is heated at 200° C. Processing the electrolyte in air has not lead to any noticeable change. The electrolyte can then be brushed on the at least one nanoparticle onto the nanogap by softening it at 90° C.

Responsivity *(not falling in the scope of the claims):*

A nanogap where CdSe/CdS nanoplatelets coated with S$^{2-}$ capping ligands have been bridged is characterized at room temperature under primary vacuum. The applied drain source is 2 V. The sample is illuminated using a 405 nm with a power between 1 and 50 mW corresponding to a flux into the nanogap of 1to 50 nW. The obtained photoresponse is 3 kA.W$^{-1}$.

Pn junction formation *(not falling in the scope of the claims)*:

HgTe quantum dots are capped using S$^{2-}$ ligands, using a phase transfer method using Na$_2$S precursor dissolved in N-methyl formamide. The nanoparticle solution is dropcasted on nanogap electrodes. Electrolyte made of LiClO$_4$ dissolved in PEG (M$_W$=6000g.mol$^{-1}$) is brushed on the nanoparticle film, while the electrolyte has been soften at 90°C. A gate electrode is deposited on the electrolyte and grounded. A source bias of 2V compared to the gate is applied and a drain bias of -2V compared to the gate is also applied while using a two channel sourcemeter. The whole system is frozen by cooling the system to a temperature below the freezing point of the electrolyte. Then a stable pn junction is formed showing a current-voltage characteristic of a diode.

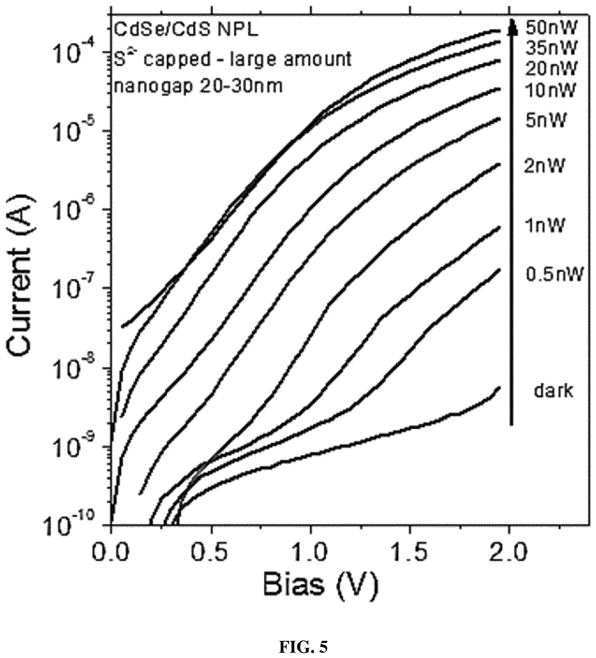

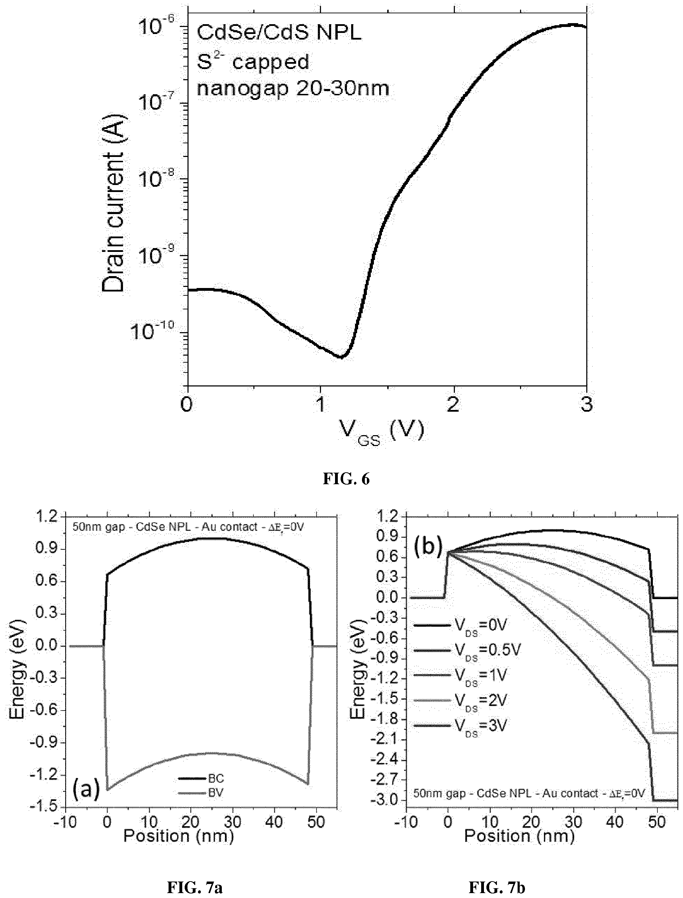

Measurement condition in view of figures 4-6:

The samples are characterized under vacuum. A drain source bias between 0 and 5 V is applied. Light illumination results from a 405 nm laser source operated with a power ranging from 0.15 mW and 50 mW. All measurements are made at room temperature.

Electroluminescence signal *(not falling in the scope of the claims)*:

On a 50 nm size nanogap device a solution of nanoplatelets (CdSe/CdS is dropcasted). The electrodes are connected to a current source (keithely 2634). As soon the applied bias overcome the band edge energy we start observing a luminescent signal which spatially overlap with the nanogap, see figure 8.

**Claims**

1.  An electronic device comprising a substrate and at least two electrodes spaced by a nanogap, wherein the at least two electrodes are bridged by at least one nanoparticle and wherein the at least one nanoparticle has at least 2% of its projected area overlapping with the at least two electrodes spaced by a nanogap, wherein the at least two electrodes each have at least one straight side, said straight sides being parallel and the distance between adjacent said straight sides defining the nanogap, **characterized in that** the at least one nanoparticle is a nanosheet, a nanoplatelet, a nanoplate, a nanowall, a nanodisk, a nanoribbon, or a nanobelt, wherein the at least one nanoparticle is inorganic, and wherein the at least one nanoparticle comprises a material selected from Ge, HgS, HgSe, HgTe, PbS, PbSe, PbTe, CuInS$_2$, CuInSe$_2$, AgInS$_2$, AgInSe$_2$.

2.  The electronic device according to claim **1,** wherein the at least one nanoparticle has at least 1% of its projected area overlapping with each of the at least two electrodes spaced by a nanogap.

3.  The electronic device according to any one of claims **1** or **2,** wherein the nanogap has a width (d) ranging from 0.1 nanometer to 1 000 nanometers, preferably from 0.25 nanometer to 500 nanometers, more preferably from 1 nanometer to 100 nanometers, even more preferably from 10 nanometers to 80 nanometers.

4.  The electronic device according to any one of claims **1** to **3,** wherein the nanogap has a length (L) ranging from 1 nanometer to 10 millimeters, preferably from 5 nanometers to 1 millimeter, more preferably from 10 nanometers to 100 micrometers, even more preferably from 50 nanometers to 10 micrometers, wherein the length (L) is the length of the at least one straight side.

5.  The electronic device according to any one of claims **1** to **4,** wherein the at least one nanoparticle is a semiconductor nanoplatelet.

6.  The electronic device according to any one of claims **1** to **5,** further comprising an electrolyte on the at least one nanoparticle.

7.  A method of manufacturing an electronic device according to any one of claims **1** to **6,** the method comprising the steps of:

    a) formation on a substrate of at least two electrodes spaced by a nanogap ranging from 0.1 nanometer to 1 000 nanometers;
    b) preparation of colloidal nanoparticles;
    c) optionally application of a nanoparticle's ligand exchange procedure;
    d) deposition of at least one nanoparticle onto the nanogap wherein the at least one nanoparticle has at least 2% of its projected area overlapping with the at least two electrodes spaced by a nanogap;
    e) application of the nanoparticle's ligand exchange procedure if not performed at step c); and
    f) optionally deposition of an electrolyte;

    **characterized in that** the nanoparticle is a nanosheet, a nanoplatelet, a nanoplate, a nanowall, a nanodisk, a nanoribbon, or a nanobelt, wherein the at least one nanoparticle is inorganic, and wherein the at least one nanoparticle comprises a material selected from Ge, HgS, HgSe, HgTe, PbS, PbSe, PbTe, $CuInS_2$, $CuInSe_2$, $AgInS_2$, $AgInSe_2$.

8. The method of manufacturing an electronic device according to claim **7,** wherein the method of formation on a substrate of at least two electrodes spaced by a nanogap is selected from electromigration, electrodeposition, mechanically controlled break junctions, e-beam lithography, self-alignment methods, lift-off methods, shadowing methods, on-wire lithography, nanotube masks.

9. The method of manufacturing an electronic device according to any one of claims **7** or **8,** wherein the method of deposition of at least one nanoparticle onto the nanogap is selected from drop casting, spin coating, dip coating, spray casting, screen printing, inkjet printing, sputtering techniques, evaporation techniques, electrophoretic deposition, gravure printing, flexographic printing or vacuum methods.

10. The method of manufacturing an electronic device according to any one of claims **7** to **9,** wherein the nanoparticle is a semiconductor nanoplatelet.

11. The electronic device according to any one of claims **1** to **6,** wherein a pn junction is formed between the at least two electrodes.

12. Use of the electronic device according to any one of claims **1** to **6** as a photodetector, a transistor, a phototransistor, an optical modulator, an electrical diode, a photovoltaic solar cell or an electroluminescent component.

13. A product comprising the electronic device according to any one of claims **1** to **6,** wherein the product is a photodetector, a transistor, a phototransistor, an optical modulator, an electrical diode, a photovoltaic solar cell, a light-emitting diode, a laser or an electroluminescent component.

**Patentansprüche**

1. Elektronische Vorrichtung, die ein Substrat und mindestens zwei Elektroden umfasst, welche um einen Nanospalt beabstandet sind, wobei die mindestens zwei Elektroden durch mindestens ein Nanopartikel verbrückt sind und wobei das mindestens eine Nanopartikel mindestens 2 % seiner projizierten Fläche mit den mindestens zwei um einen Nanospalt beabstandeten Elektroden überlappend aufweist, wobei die mindestens zwei Elektroden jede mindestens eine gerade Seite aufweisen, wobei die geraden Seiten parallel sind und der Abstand zwischen benachbarten der geraden Seiten den Nanospalt definiert, **dadurch gekennzeichnet, dass** das mindestens eine Nanopartikel eine Nanofolie, ein Nanoplättchen, eine Nanoplatte, eine Nanowand, eine Nanoscheibe, ein Nanoband oder ein Nanogürtel ist, wobei das mindestens eine Nanopartikel anorganisch ist, und wobei das mindestens eine Nanopartikel ein Material umfasst, ausgewählt aus Ge, HgS, HgSe, HgTe, PbS, PbSe, PbTe, $CuInS_2$, $CuInSe_2$, $AgInS_2$, $AgInSe_2$.

2. Elektronische Vorrichtung nach Anspruch **1,** wobei das mindestens eine Nanopartikel mindestens 1 % seiner projizierten Fläche mit jeder der mindestens zwei um einen Nanospalt beabstandeten Elektroden überlappend aufweist.

3. Elektronische Vorrichtung nach einem der Ansprüche **1** oder **2,** wobei der Nanospalt eine Breite (d) im Bereich von 0,1 Nanometer bis 1.000 Nanometer, vorzugsweise von 0,25 Nanometer bis 500 Nanometer, stärker bevorzugt von 1 Nanometer bis 100 Nanometer, noch stärker bevorzugt von 10 Nanometer bis 80 Nanometer aufweist.

4. Elektronische Vorrichtung nach einem der Ansprüche **1** bis **3,** wobei der Nanospalt eine Länge (L) im Bereich von 1 Nanometer bis 10 Millimeter, vorzugsweise von 5 Nanometer bis 1 Millimeter, stärker bevorzugt von 10 Nanometer bis 100 Mikrometer, noch stärker bevorzugt von 50 Nanometer bis 10 Mikrometer aufweist, wobei die Länge (L) die Länge der mindestens einen geraden Seite ist.

5. Elektronische Vorrichtung nach einem der Ansprüche **1** bis **4,** wobei das mindestens eine Nanopartikel ein Halbleiter-Nanoplättchen ist.

6. Elektronische Vorrichtung nach einem der Ansprüche **1** bis **5,** weiter einen Elektrolyt auf dem mindestens einen Nanopartikel umfassend.

7. Verfahren zur Herstellung einer elektronischen Vorrichtung nach einem der Ansprüche **1** bis **6,** wobei das Verfahren die Schritte umfasst des:

   a) Bildens von mindestens zwei Elektroden auf einem Substrat, die um einen Nanospalt im Bereich von 0,1 Nanometer bis 1.000 Nanometer beabstandet sind;
   b) Anfertigens von kolloidalen Nanopartikeln;
   c) gegebenenfalls Anwendens eines Nanopartikel-Ligandenaustauschvorgangs;
   d) Abscheidens von mindestens einem Nanopartikel auf dem Nanospalt, wobei das mindestens eine Nanopartikel mindestens 2 % seiner projizierten Fläche mit den mindestens zwei um einen Nanospalt beabstandeten Elektroden überlappend aufweist;
   e) Anwendens des Nanopartikel-Ligandenaustauschvorgangs, wenn nicht bei Schritt c) durchgeführt; und

f) gegebenenfalls Abscheidens eines Elektrolyten;

**dadurch gekennzeichnet, dass** das Nanopartikel eine Nanofolie, ein Nanoplättchen, eine Nanoplatte, eine Nanowand, eine Nanoscheibe, ein Nanoband oder ein Nanogürtel ist, wobei das mindestens eine Nanopartikel anorganisch ist, und wobei das mindestens eine Nanopartikel ein Material umfasst, ausgewählt aus Ge, HgS, HgSe, HgTe, PbS, PbSe, PbTe, $CuInS_2$, $CuInSe_2$, $AgInS_2$, $AgInSe_2$.

8. Verfahren zur Herstellung einer elektronischen Vorrichtung nach Anspruch **7,** wobei das Verfahren zur Bildung von mindestens zwei um einen Nanospalt beabstandeten Elektroden auf einem Substrat ausgewählt ist aus Elektromigration, Elektroabscheidung, mechanisch kontrollierten Bruchkontakten, Elektronenstrahllithographie, Selbstausrichtungsverfahren, Abhebeverfahren, Schattierungsverfahren, Drahtlithographie, Nanoröhrchen-Masken.

9. Verfahren zur Herstellung einer elektronischen Vorrichtung nach einem der Ansprüche **7** oder **8,** wobei das Verfahren zum Abscheiden von mindestens einem Nanopartikel auf dem Nanospalt ausgewählt ist aus Fallguss, Schleuderbeschichten, Tauchbeschichten, Sprühguss, Siebdruck, Tintenstrahldruck, Sputtertechniken, Verdampfungstechniken, elektrophoretischer Abscheidung, Tiefdruck, Flexodruck oder Vakuumverfahren.

10. Verfahren zur Herstellung einer elektronischen Vorrichtung nach einem der Ansprüche **7** bis **9,** wobei das Nanopartikel ein Halbleiter-Nanoplättchen ist.

11. Elektronische Vorrichtung nach einem der Ansprüche **1** bis **6,** wobei zwischen den mindestens zwei Elektroden ein pn-Übergang gebildet ist.

12. Verwendung der elektronischen Vorrichtung nach einem der Ansprüche **1** bis **6** als ein Photodetektor, ein Transistor, ein Phototransistor, ein optischer Modulator, eine elektrische Diode, eine photovoltaische Solarzelle oder ein elektrolumineszentes Bauteil.

13. Produkt, das die elektronische Vorrichtung nach einem der Ansprüche **1** bis **6** umfasst, wobei das Produkt ein Photodetektor, ein Transistor, ein Phototransistor, ein optischer Modulator, eine elektrische Diode, eine photovoltaische Solarzelle, eine lichtemittierende Diode, ein Laser oder ein elektrolumineszentes Bauteil ist.

**Revendications**

1. Un dispositif électronique comprenant un substrat et au moins deux électrodes espacées par un nanogap, dans lequel les au moins deux électrodes sont pontées par au moins une nanoparticule et dans lequel la au moins une nanoparticule a au moins 2% de sa surface projetée chevauchant les au moins deux électrodes espacées par un nanogap, dans lequel les au moins deux électrodes ont chacune au moins un côté droit, lesdits côtés droits étant parallèles et la distance entre des côtés droits adjacents définissant le nanogap, **caractérisé en ce que** la au moins une nanoparticule est un nanofeuillet, une nanoplaquette, une nanoplaque, un nanomur, un nanodisque, un nanoruban ou une nanoceinture, dans lequel la au moins une nanoparticule est inorganique, et dans lequel la au moins une nanoparticule comprend un matériau sélectionné parmi Ge, HgS, HgSe, HgTe, PbS, PbSe, PbTe, $CuInS_2$, $CuInSe_2$, $AgInS_2$, $AgInSe_2$.

2. Le dispositif électronique selon la revendication **1,** dans lequel la au moins une nanoparticule a au moins 1% de sa surface projetée chevauchant les au moins deux électrodes espacées par un nanogap.

3. Le dispositif électronique selon l'une quelconque des revendications **1** ou **2,** dans lequel le nanogap a une largeur (d) allant de 0.1 nanomètre à 1 000 nanomètres, de préférance de 0.25 nanomètre à 500 nanomètres, plus préférentiellement de 1 nanomètre à 100 nanomètres, encore plus préférentiellement de 10 nanomètres à 80 nanomètres.

4. Le dispositif électronique selon l'une quelconque des revendications **1** à **3,** dans lequel le nanogap a une longueur (L) allant de 1 nanomètre à 10 millimètres, de préférance de 5 nanomètres à 1 millimètre, plus préférentiellement de 10 nanomètres à 100 micromètres, encore plus préférentiellement de 50 nanomètres à 10 micromètres, dans lequel la longueur (L) est la longueur du au moins un côté droit.

5. Le dispositif électronique selon l'une quelconque des revendications **1** à **4,** dans lequel la au moins une nanoparticule est une nanoplaquette semiconductrice.

6. Le dispositif électronique selon l'une quelconque des revendications **1** à **5,** comprenant en outre un électrolyte sur la au moins une nanoparticule.

7. Une méthode de fabrication d'un dispositif électronique selon l'une quelconque des revendications **1** à **6,** la méthode comprenant les étapes de :

a) formation sur un substrat d'au moins deux électrodes espacées par un nanogap allant de 0.1 nanomètre à 1 000 nanomètres ;

b) préparation de nanoparticules colloïdales ;

c) application optionnelle d'une procédure d'échange de ligand d'une nanoparticule ;

d) dépôt d'au moins une nanoparticule sur le nanogap dans lequel la au moins une nanoparticule a au moins 2% de sa surface projetée chevauchant les au moins deux électrodes espacées par un nanogap ;

e) application d'une procédure d'échange de ligand d'une nanoparticule si non effectuée à l'étape c) ; et

f) dépôt optionnel d'un électrolyte ;

**caractérisé en ce que** la au moins une nanoparticule est un nanofeuillet, une nanoplaquette, une nanoplaque, un nanomur, un nanodisque, un nanoruban ou une nanoceinture, dans lequel la au moins une nanoparticule est inorganique, et dans lequel la au moins une nanoparticule comprend un matériau sélectionné parmi Ge, HgS, HgSe, HgTe, PbS, PbSe, PbTe, CuInS$_2$, CuInSe$_2$, AgInS$_2$, AgInSe$_2$.

8. La méthode de fabrication d'un dispositif électronique selon la revendication **7,** dans laquelle la méthode de formation sur un substrat d'au moins deux électrodes espacées par un nanogap est sélectionnée parmi l'électromigration l'électrodépôt, la jonction brisée controlée mécaniquement, la lithographie à faisceau d'électrons, méthodes d'auto-alignement, méthode du lift-off, méthodes de masquage, lithographie sur fil, masques nanotubes.

9. La méthode de fabrication d'un dispositif électronique selon l'une quelconque des revendications **7** ou **8,** dans laquelle la méthode de dépôt d'au moins une nanoparticule sur le nanogap est sélectionnée parmi le dépôt de gouttes, l'enduction centrifuge, le trempage retrait, le dépôt par vaporisation, la sérigraphie, l'impression à jet d'encre, des techniques de vaporisation, des techniques d'évaporation, le dépôt électrophorétique, l'héliogravure, l'impression flexographique ou des méthodes sous vide.

10. La méthode de fabrication d'un dispositif électronique selon l'une quelconque des revendications **7** ou **9,** dans laquelle la nanoparticule est une nanoplaquette semiconductrice.

11. Le dispositif électronique selon l'une quelconque des revendications **1** à **6,** dans lequel une jonction pn est formée entre les au moins deux électrodes.

12. Utilisation du dispositif électronique selon l'une quelconque des revendications **1** à **6** comme photodétecteur, transistor, phototransistor, modulateur optique, diode électrique, cellule photovoltaïque solaire ou composant électroluminescent.

13. Un produit comprenant le dispositif électronique selon l'une quelconque des revendications **1** à **6,** dans lequel le produit est un photodétecteur, un transistor, un phototransistor, un modulateur optique, une diode électrique, une cellule photovoltaïque solaire, une diode émettrice de lumière ou composant électroluminescent.

FIG. 1

FIG. 2

FIG. 3

FIG. 4

**FIG. 5**

**FIG. 6**

**FIG. 7a**                    **FIG. 7b**

**FIG. 8**

**FIG. 9**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20080108172 A

**Non-patent literature cited in the description**

- **PARK et al.** *Applied Physics Letters,* 1999, vol. 75, 301

- **KLEIN et al.** *Applied Physics Letters,* 1996, vol. 68, 2574